# EUROPÄISCHE PATENTANMELDUNG

(11) **EP 2 482 082 A1**
(43) Veröffentlichungstag der Anmeldung: **01.08.2012**
(21) Anmeldenummer: 12153080.2
(22) Anmeldetag: 30.01.2012
(51) Int. Cl.: G01R 11/04, G01R 22/06

(54) **Stromzähleranschlusssystem**

(30) Priorität: 31.01.2011 DE 102011009904
(71) Anmelder: Hager Electro GmbH & Co. KG, 66440 Blieskastel (DE)
(72) Erfinder:
(74) Vertreter: Bernhardt, Reinhold

(57) **Zusammenfassung**

Die Erfindung betrifft ein Stromzähleranschlusssystem der Elektroinstallation von Gebäuden, mit einer Stromzöhlerbaueinheit (1) und einer Befestigungs- und Kontaktiereinrichtung (10) an welche die Stromzählerbaueinheit (1) elektrisch und mechanisch koppelbar und die mit zu zählenden Strom zuführenden und gezählten Strom abführenden Leitern verbindbar ist. Gemäß der Erfindung weist die Befestigungs- und Kontaktiereinrichtung (10) Mittel (22) zur Erzeugung eines von der Stärke des zu zählenden Stroms abhängiges, durch die Stromzählerbaueinheit (1) auswertbare elektrischen Signals auf und im Zuge der Ankopplung der Stormzählerbaueinheit (1) an die Befestigungs- und Kontaktiereinrichtung (10) sind das elektrische Signal führende Leitungen (33,34) der Befestigungs- und Kontaktiereinrichtung (10) mit der Stromzählerbaueinheit (1) elektrisch verbindbar.

## Beschreibung

Die Erfindung betrifft ein stromzähleranschlusssystem der Elektroinstallation von Gebäuden, mit einer Stromzählerbaueinheit und befestigung- und Kontaktiereinrichtung, an welche die Stromzählerbaueinheit elektrisch und mechanisch koppelbar und die mit zu zählenden Strom zuführenden un gezählten Strom abführenden Leitern verbindbar ist.

Bekanntermaßen wird in solchen, vor alle in Haushalten eingesetzten Stromzähleranschlusssystemen der zu zählende bzw. zu messende Strom über die Befestigungs- und Kantaktiereinrichtung durch die Stromzählerbaueinheit hindurch geleitet und zur Ermittlung des Elektroenergieverbrauchs innerhalb der Stromzählerbaueinheit ein von der Stromstärke abhängiges signal erzeugt.

Durch die vorliegende Erfindung wird ein neues Stromzähleranschlusssystem der eingangs genannten Art geschaffen, ass dadurch gekennzeichnet ist, dass die Befestigungs- und Kantaktiareinriahtun Mittel zur Erzeugung eines von der Stärke des zu zählenden Stroms abhängigen, durch die Stromzählerbaueinheit auswertbare elektrischen Signals aufweist und das im Zuge der Ankopplung der Stromzählerbaueinheit an die Befestigungs- und Kontaktiereinrichtung das elektrische Signal führende Leitungen der Befestigungs- und Kontaktiereinrichtung mit der Stromzählerbaueinheit elektrisch verbindbar sind.

Gemäß der Erfindung fließt zu zählender Strom nur noch innerhalb der Befestigungs- und Kontaktiereinrichtung, die ein durch die Stromzählerbaueinheit auswertbares, von der zu erfassenden Stromstärke abhängiges elektrisches Signal liefert, Eine für höhere Stromstärken ausgelegte Kontaktierung zwischen der Stromzählerbaueinheit und der Befestigungs- und Kontaktiereinrichtung kann vorteilhaft entfallen.

Vorzugsweise handelt es sich bei dem elektrischen Signal um ein Spannungssignal, dass über einem von zu zählendem Strom durchflossenen Messwiderstand abfällt. Dieser vorzugsweise als Shuntwiderstand ausgebildete Messwiderstand liefert von Temperaturschwankungen weitgehend unbeeinflusstes Signal, das die Stromzählerbaueinheit dann nur noch zu verstärken und auszuwerten braucht. Über die Signalleitungen und eine weitere, mit dem Neutralleiter verbundene Leitung lässt sich der Stromzählerbaueinheit darüber hinaus eine Versorgungsspannung zuführen und über die genannten Leitungen ferner die Phasenspannung messen. Somit stehen der Stromzählerbaueinheit alle zur Ermittlung des Elektroenergieverbrauchs erforderliche Größen zur Verfügung.

In einer weiteren bevorzugten Ausführungsform der Erfindung weist die Befestigungs- und Kontaktiereinrichtun eine Schalteinrichtung zur Unterbrechung des durch die Befestigungs- und Kontaktiereinrichtun fließenden, zu zählenden Stroms auf. Über diese Schaltvorrichtung, die vorzugsweise durch das Stromversorgungsunternehmen fernsteuerbar ist, lässt sich die Stromversorgung bei Bedarf aufheben und wieder herstollen. Für die Schalteinrichtung kommt, zusätzlich oder ausschließlich, auch eine manuelle Betätigung in Betracht.

In einer Ausführungsform der Erfindung weist die Befestigungs- und Kontaktiereinrichtung Mittel zum Abgreifen einer Versorgungsspannung für den Stromzähler, die Schalteinrichtung oder/und wenigstens ein weiteres Zusatzgerät vor oder/und hinter der Einrichtung zur Erzeugung des elektrischen Signals auf. Je nachdem, ob vor oder hinter der Einrichtung zur Erzeugung des elektrischen Signals abgegriffen wird, erfolgt die Versorgung des betreffenden Geräts mit gezähltem oder ungezähltem Strom. Die genannte Schalteinrichtung kann vor oder hinter der Einrichtung zur Erzeugung des elektrischen Signals angeordnet sein, wobei vorzugsweise Mittel zum Abgreifen einer Versorgungsspannung zumindest für die Schalteinrichtung vor der Schaltereinrichtung vorgesehen sind. Die Schalteinrichtung bleibt somit betriebsbereit und durch Schließen der Schalteinrichtung lassen sich hinter der Schalteinrichtung wieder Versorgungsspannungen abgreifen.

In einer besonders bevorzugten Ausführungsform der Erfindung sind die Leitungen im Zuge der mechanischen Ankopplung der stromzählerbaueinheit an die Befestigungs- und Kontaktiereinrichtung mit der Stromzählerbaueinheit automatisch verbindbar, wobei insbesondere ein Anschluss der Stromzählerbaueinheit an die Leitungen über eine Steckverbindung vorgesehen ist.

Von einer der Befestigungs- und Kontaktiereinrichtung zugewandten Unterseite der Stromzähterbaueinheit können Einrichtungen zur Herstellung einer solchen Steckverbindung vorstehen, wobei vorzugsweise in einer die Stromzählerbaueinheit aufnehmenden Zöhlertragplatte der Befestigungs- und Kontaktiereinrichtung in Öffnung für den Eingriff der von der Stromzöhlerbaueinheit vorstehenden Einrichtungen für die Herstellung Steckverbindung gebildet ist.
Vorteilhaft ist die Steckverbindung durch die auf die Zöhlertragplotte aufgesetzte, in einer Anschlussstellung plombierbare Stromzählerbaueinheit abgedeckt und die genannte Öffnung ist verschlossen. Vorteilhaft besteht keinerlei Zugangsmöglichkeit zum Inneren der Befestigungs- und Kontaktiereinrichtung sowie deren Anschlussklemmen.

Vorzugsweise ist die Stromzöhlerbaueinheit zur mechanischen Ankopplung an die Befestigungs- und Kontaktiereinrichtung unter Verschiebung auf der Zählertragplatte mit der Zählertragplatte verhakbar, wobei vorzugsweise im Zuge der Verschiebung automatisch die genannte Verbindung, insbesondere Steckverbindung, wischen den genannten Leitungen und dem Stromzähler herstellbar ist.

Die für den oben genannten Messwiderstand erforderliche Eichung lässt sich so durchführen, dass zur Einstellung eines bestimmten Widerstandswertes Widerstandsmaterial ab- oder aufgetragen und/oder die Länge zwischen den Abgriffskontakten der abfallenden Messspannung Widerstands variiert wird. Zum Beispiel könnte der Messwiderstand systematisch mit zu geringem Widerstandswert geliefert und eine zur Widerstandserhöhung erforderlich Querschnittsverringerung, z.B. mit Hilfe eines Bohrers, Fräsers oder Lasers durchgeführt werden.

Die Stromzählerbaueinheit oder die Befestigungs- und Kontaktiereinrichtung könnte einen Temperaturfühler zur Erzeugung eines Korrektursignals aufweisen, das durch eine noch vorhandene geringe Temperaturabhängigkeit des Messwiderstands bewirkte Messfehler korrigiert.

Die Erfindung wird nachfolgend anhand von Ausführungsbeispielen und der beiliegende, sich auf diese Ausführungsbeispiele beziehenden Zeichnungen weiter erläutert. Es zeigen:
- Fig. 1: eine Stromzöhlerbaueinheit eines erfindungsgemäßen Stromzöhleranschlusssystems,
- Fig. 2: eine Befestigungs- und Kontoktiereinrichtung eines erfindungsgemäßen Stromzöhleranschlusssystems,
- Fig. 3: den Innenaufbau der Befestigungs- und Kontaktiereinrichtung von Fig. 2,
- Fig. 4: eine schematische Darstellung einer Befestigungs- und Kontaktiereinrichtung entsprechend einem weiteren Ausführungsbeispiel für die Erfindung,
- Fig. 5: ein drittes Ausführungsbeispiel für ein erfindungsgemäßes Stromzähleranschlusssystem.
- Fig. 6: in dem Anschlusssystem von Fig. 5 verwendbare Shuntwiderstände, und
- Fig. 7: eine Befestigungs- und Kontaktiereinrichtung gemäß einem vierten Ausführungsbeispiel für die Erfindung und Fig. 8 ein fünftes Ausführungsbeispiel für eine Befestigungs- und Kontaktiereinrichtun nach der Erfindung.

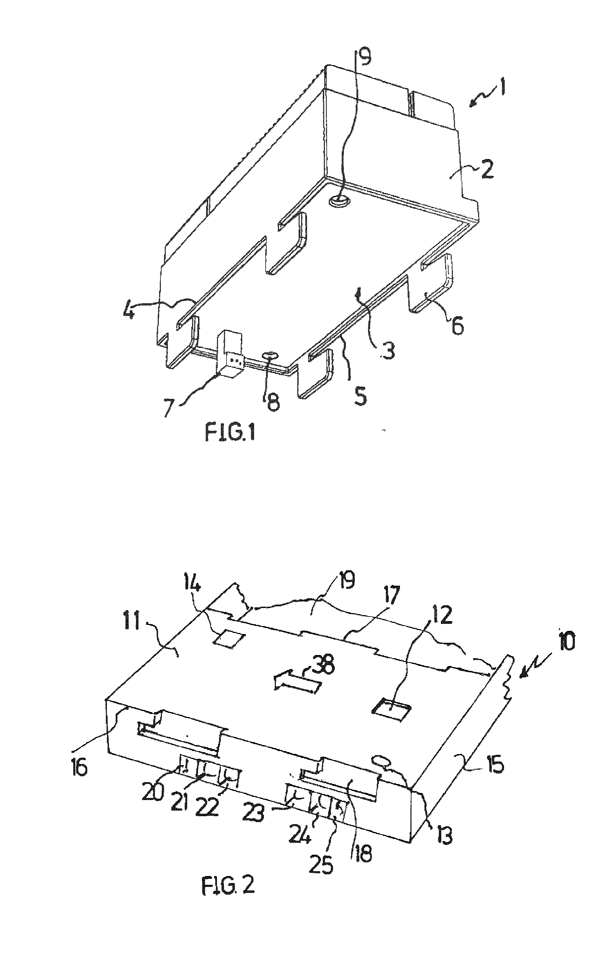

Eine in Fig. 1 gezeigte, einen elektronischen Haushaltszähler bildende Stromzählerbaueinheit 1 mit einem etwa quaderförmigen Kunststoffgehäuse 2 weist eine ebene Unterseite 3 auf. Von einander gegenüberliegenden Längsrändern 4 und 5 der Unterseite 3 stehen je zwei Hakenelemente 6 vor. Ein von der Unterseite 3 ferner vorstehendes Steckerelement 7 ist mit Steckerstiften oder Steckerbuchsen für die Herstellung einer Steckverbindung in zur Unterseite 3 paralleler Steckrichtung versehen.

Zu der Unterseite 3 in öffnet ein Durchgangskanal 8 für die Aufnahme eines plombierbaren Arretierungsstiftes (nicht gezeigt). Bei 9 auf der Unterseite 3 befindet sich ein Fenster für eine opto-elektronische Schnittstelle.

Fig. 2 zeigt eine zur Aufnahme der in Fig. 1 dargestellten Stromzählerbaueinheit 1 vorgesehene Befestigungs- und Kontaktiereinrichtung 10 mit einer Zählertragplatte 11. In der Zählertragplatte 11 befinden sich Öffnung 12 für die Aufnahme des Steckerelements 7 sowie eine Öffnung 13 zur Einführung des oben genannten Arretierungsstifts. Ein Fenster 14 in der Zählertragplatte 11 dient der Bildung der erwähnten opto-elektronischen Schnittstelle, Die Zöhiertragpiatte 11 schließt die Oberseite Gehäuses 15 ab.

An einander gegenüberliegenden Längsseiten 16 und 17 der Tragplatte 11 sind in dem Gehäuse 15 je zwei Ausnehmungen 18 für die Aufnahme der Hakenelemente 6 der Stromzählerbaueinheit 1 gebildet.

In dem gezeigten Ausführungsbeispiel weist die Befestigungs- und Kontaktiereinrichtung 10 im Anschluss an den Längsrand 17 der Zöhlertragplatte 11 einen Bereich 19 für die Aufnahme zusätzlicher Geräte (nicht gezeigt) auf.

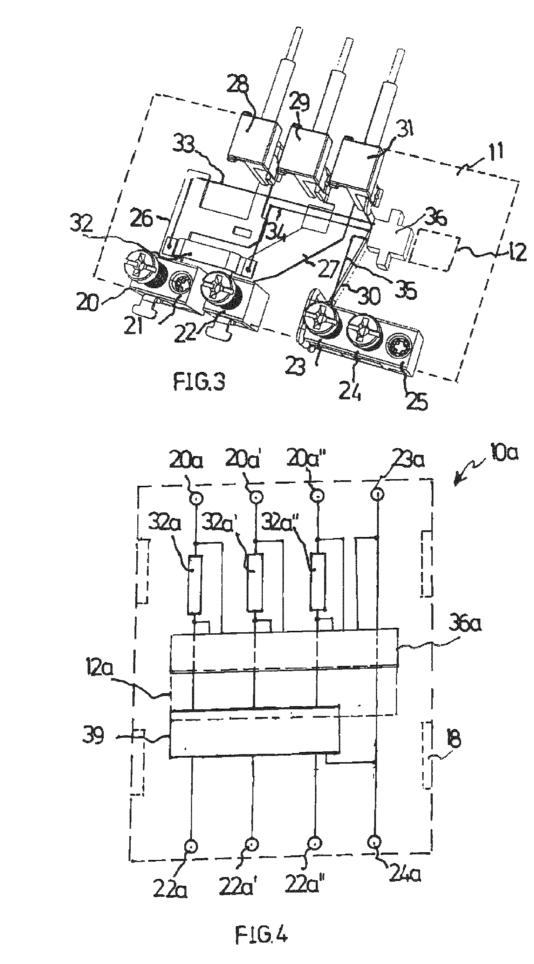

Fig. 3 zeigt Teile des Innenaufbaus der in Fig. 2 dargestellten Befestigungs- und Kontaktiereinrichtung 10. Die Zählertragplatte 11 der Befestigungs- und Kontaktiereinrichtung 10 mit der Öffnung 12 ist in Fig. 3 durch Strichlinien angedeutet.

In dem Gehäuse 15 sind unter der Zählertragplatte 11 (auch in Fig. 2 teilweise sichtbare) Schraubklemmanschlusselemente 20-25 untergebracht. Das Schraubklemmanschlusselement 20 dient der Anklemmung eines Strom zuführenden Kabels, das Schraubklemmanschlusselement 22 der Anklemmung eines Strom abführenden Kabels. An die Schraubklemmanschlusselemente 23 und 24 können Neutralleiterkabel angeschlossen werden. Die beiden schraubklemmanschlusselemente 21 und 25 ermöglichen einen Abgriff der Netzspannung als Versorgungsspannung für Zusatzgeräte, z.B. Schalt- oder/und Kommunikationsgeräte.

Die Schraubklemmanschlusselemente 20 und 22 sind mit je einem Leiterstück 26 bzw. 27 verbunden. Das Leiterstück 26 führt zu einem Steckklemmanschlusselement 28. Das Leiterstück 27 zu einem Steckklemmanschlusselement 29.

Die beiden Schraubklemmanschlusselemente 23 und 24 sind mit einem drahtförmigen Leiterstück 30 verbunden, das zu einem Steckklemmanschlusselement 31 führt. Auch an den Steckklemmanschlusselementen 28, 29 sowie dem Steckklemmanschlusselement 31 können Versorgungsspannungen für Zusatzgeräte abgegriffen werden, wobei wahlweise Abgriffe für gezählten oder ungezählten Strom auswählbar sind.

Die Leiterstücke 26 und 27 sind über einen z.B. aus Konstanten oder/und Manganin bestehenden Shuntwiderstand 32 kurz geschlossen. Von den Enden des Shuntwiderstands 32 führt jeweils eine Signalleitung 33 bzw. 34 zu einem Steckerelement 36, weitere Leitung 35 ist von dem mit dem Neutralleiterkabel verbindbaren Schraubklemmenanschlusselement 23 zu dem Steckerelement 36 geführt.

Die in Fig. 2 gezeigte Befestigungs- und Kontaktierungseinrichtung 10 bildet einen Adapter, der am Zählerkreuz einer Zählerplatzbaueinheit für den Anschluss eines herkömmlichen elektromechanischen Stromzählers vorgesehen ist. Es versteht sich, dass die hier als Beispiel beschriebene Befestigungs- und Kontaktiereinrichtung selbst Bestandteil einer kompletten, mit Anschlussräumen versehenen Zöhlerplatzbaueinheit für die Aufnahme eines elektronischen Stromzählers, wie er in Fig. 1 gezeigt ist, sein könnte.

Zur Verbindung der in Fig.1 gezeigten Stromzählerbaueinheit 1 mit der Befestigungs- und Kontaktiereinrichtung 10 wird die Stromzählerbaueinheit 1 auf die Tragplatte 11 der Befestigungs- und Kontaktiereinrichtung 10 aufgesetzt, wobei die Hakenelemente 6 in die seitlichen Ausnehmungen 18 an den Längsrändern 16 und 17 eingreifen. Das mit dem Boden 3 der Stromzöhlerbaueinheit 1 verbundene Steckerelement 7 steht dann durch die Öffnung 12 in der Tragplatte 11 in das Innere des Gehäuses 15 hinein vor. Das Fenster 8 für die opto-elektronische Schnittstelle an der Unterseite 3 der Stromzählerbciueinheit ist nun zu dem Fenster 14 in der Tragplatte 11 ausgerichtet.

Zur mechanischen Befestigung der Stromzähierbaueinheit 1 an der Befestigungs- und Kontaktiereinrichtung 10 wird die Stromzählerbaueinheit 1 auf der Tragplatte 11 in Richtung des Pfeils 38 verschoben, wobei sich die Hakenelemente 6 in den hinterschnittenen Ausnehmungen 18 verhaken. Der Durchgangskanal 8 fluchtet mit der Öffnung 14 in der Tragplatte 1, so dass sich die Stromzählerbaueinheit 1 durch den genannten plombierbaren Bolzen in der Anschlussstellun arretieren und sichern lässt.

Mit der Verschiebung der Stromzöhlerbaueinheit 1 auf der Tragplatte 11 wird automatische eine Steckverbindung zwischen dem Steckerelement 7 an der Unterseite 3 der Stromzähferboueinheit 1 un dem Steckerelement 36 im Gehäuse 15 der Befestigungs- und Kontaktiereinrichtun 10 hergestellt.

Zu zählender Strom fließt über den Shuntwiderstand 32 und sorgt für einen Spannungsabfall, der mit Hilfe der Signalleitungen 33 und 34 abgegriffen und durch die Stromzählerbaueinheit 1, die über die Steckerelemente 7 und 36 mit den Signalleistungen 33 und 34 verbunden ist, verstärkt und ausgewertet wird. Die abgegriffene Spannung ist dem durch den Shuntwiderstand 32 fließenden Strom proportional. Der Shuntwiderstand behält unabhängig von der Umgebungstemperatur seinen Widerstandswert bei.

Über die Signalleitung 33 oder 34 und die Leitung 35 wird der stromzählerbaueinheit 1 zudem eine Betriebsspannung zugeführt und die Stromzählerbaueinheit 1 ist ferner in der Lage, diese Spannung zu messen. Aus dem über den Spannungsabfall am Shuntwiderstand ermittelten Strom und der ermittelten Spannung berechnet die Stromzählerbaueinheit 1 dann den Verbrauch an Elektroenergie.

Es versteht sich, dass das vorangehend beschriebene, einen Shuntwiderstand nutzende Stromzähleranschlusssystem auch mehrphasig ausgelegt werden kann. Fig. 4 zeigt schematisch ein Ausführungsbeispiel für eine mehrphasige Befestigungs- und Kontaktiereinrichtung 10a.

Die Befestigungs- und Kontaktiereinrichtung 10a weist Anschlusselemente 20a, 20a' und 20a'' für den Anschluss zu zahlenden Strom führender Kabel sowie Anschlusselemente 22a, 22a' und 22a" für den Anschluss gezählten Strom abführenden Kabel entsprechend drei Stromphasen L1, L2 und L3 auf. Ferner sind Anschlüsse 23a und 24a für den Anschluss von Neutralleiterkabeln vorgesehen. Die Phasenanschlüsse sind jeweils über einen Shuntwiderstand 32a, 32a' bzw. 32a" und eine Schalteinrichtung 39 miteinander verbunden. Von den Enden der Shuntwiderstände sind jeweils zwei Signalleitungen zu einer Steckanschlussleiste 36a geführt. Ferner ist die Steckanschlussleiste 36a mit dem Neutralleiter verbunden. Die Schalteinrichtungen 39 ist zwecks Spannungsversorgung ebenfalls an den Neutralleiter angeschlossen.

Eine durch Strichlinien angedeutete Zöhlertragplatte 11a weist eine Öffnung 12a auf, die in ihren Abmessungen der Steckerleiste 36a entspricht, so dass ein mit einer Stromzöhlerbaueinheit verbundenes Steckergegenelement (nicht gezeigt) durch diese Öffnungen treten kann.

Eine auf die Zöhlertragplatte 11a aufgesetzte und parallel dazu verschobener Stromzählerbaueinheit (nicht gezeigt) verhakt sich in seitlichen Ausnehmungen 18a, währen automatisch eine Steckverbindung zwischen dem genannten Steckergegenelement und der Steckerleiste 36a hergestellt wird. Die Stromzählerbaueinheit ist über die hergestellte Steckverbindung nun mit den Abgriffspunkten an den Shuntwiderständen und mit einem Abgriffspunkt am Neutralleiter verbunden. Damit liegt an der Stromzählerbaueinheit eine Versorgungsspannung an und die Stromzählerbaueinheit kann aus den abgegriffenen Spannungen die jeweilige Spannungsdifferenz über den Shuntwiderstanden ermitteln.

Die Schalteinrichtung 39, die in dem gezeigten Ausführungsbeispiel ferner steuerbar ist, erlaubt eine Unterbrechung des Stromflusses und damit eine stilllegung des Anschlusssystems. Ebenso kann das Anschlusssystem durch Fernsteuerung wieder in Betrieb genommen werden. Es versteht sich, dass auch das anhand der Fig. 1 bis 3 beschriebene Anschlusssystem eine solche Schalteinrichtung aufweisen könnte.

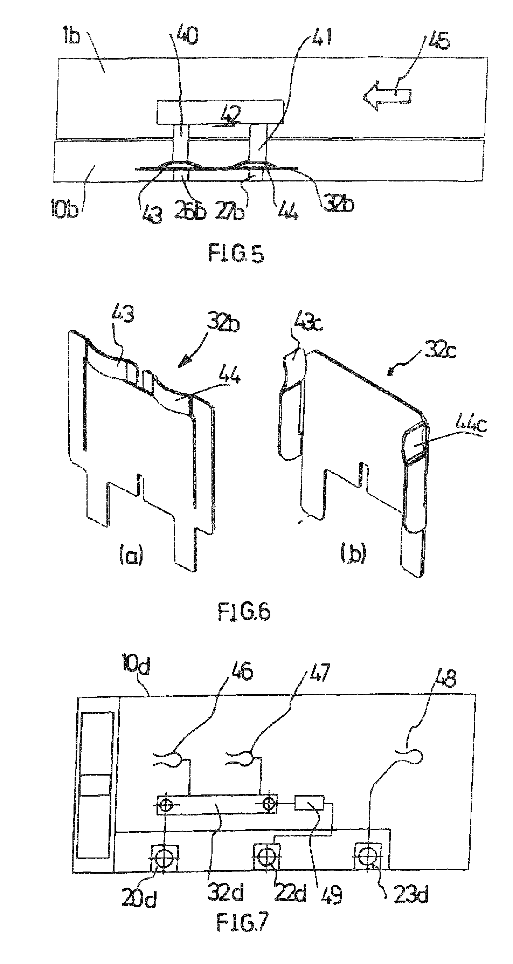

Fig. 5 zeigt schematisch ein Stromzähleranschlusssystem mit einer Stromzählerbaueinheit 1 b und einer Befestigungs- und Kontaktiereinrichtung 10b.

Von der Stromzählerbaueinheit 1 b stehen Kontaktstücke 40 und 41 vor, die mit einer in der Stromzählerbaueinheit 1b vorgesehenen Auswerteinrichtung 42 verbunden sind.

Ein in der Befestigungs- und Kontaktiereinrichtung 10b vorgesehener Shuntwiderstand 32b ist mit Strom zu- und abführenden Leiterstücken 26b und 27b verbunden. Zur Verbindung mit der Befestigungs- und Kontaktiereinrichtung 10b ist die Stromzählerbaueinheit 1b gemäß Pfeil 45 zu verschieben, wobei die Kontaktstücke 40 und 41 mit elastischen Zungen 43 und 44 des Shuntwiderstands 32b in Kontakt kommen, um eine über dem Shuntwiderstand abfallende Messspannung abzugreifen.

Fig. 6a zeigt gesondert den Shuntwiderstand 32b mit den elastisch abbiegbaren Kontaktzungen 43 und 44. Fig. 6b zeigt einen Shuntwiderstand mit in anderer Weise als bei dem Ausführungsbeispiel von Fig. 6a gestalteten Kontaktzungen 43c und 44c.

Eine in Fig. 7 gezeigte Befestigungs- und Kontaktiereinrichtung weist Anschlusselemente 20d und 22d für zu- und abfließenden Strom sowie ein Anschlusselement 23d für den Anschluss eines Neutralleiterkabels auf. Den Zählstrom führende Leiter sind über einen Shuntwiderstand 32d miteinander verbunden. Die bei dem Shuntwiderstand 32d abfallende Spannung kann mit Hilfe von einer Stromzählerbaueinheit vorstehenden Kontaktstücken (nicht gezeigt) an tulpenartigen Kontaktelementen 46 und 47 abgegriffen werden. Ein weiteres von der Stromzählerbaueinheit vorstehendes (nicht gezeigtes) Kontaktstück kommt mit einem Neutralleiterkontaktelement 48 in Verbindung.

Bei 49 ist schematisch eine Unterbrechungseinrichtung gezeigt, die bei abgenommener Stromzählerbaueinheit den Stromfluss verhindert und die durch Verschieben des Stromzählers unter Kontaktierung der tulpenartigen Kontaktelemente durch den Stromzähler geschlossen werden kann.

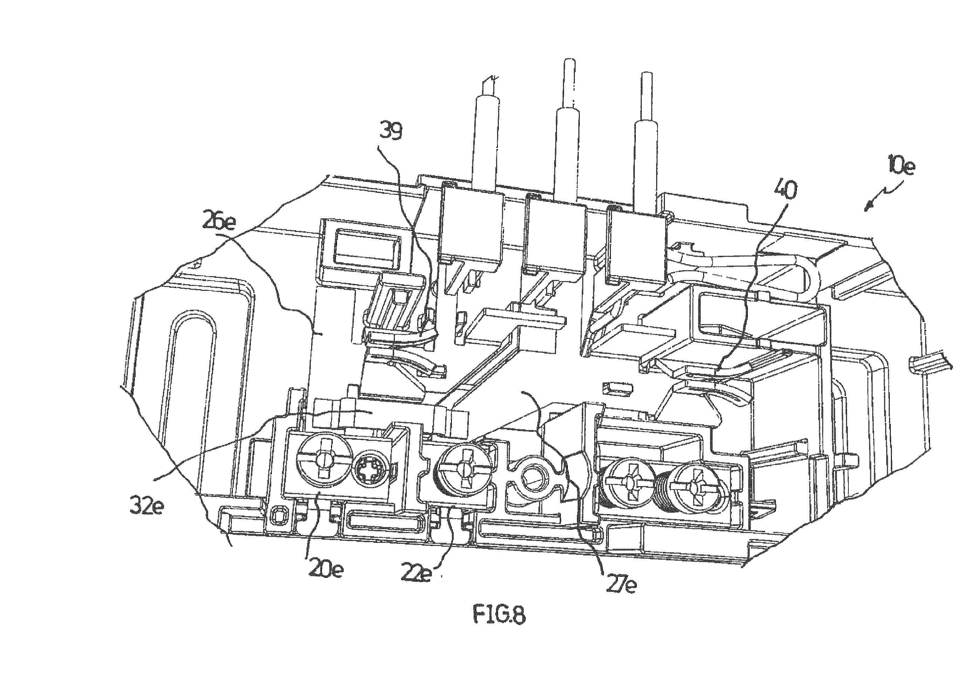

Fig. 8 zeigt ein Ausführungsbeispiel für eine Befestigungs- und Kontaktiereinrichtung 10e, deren Innenaufbau weitgehend dem in Fig. 3 gezeigten Innenaufbau der Befestigungs- und Kontaktiereinrichtung von Fig. 2 entspricht.

Von Leiterstücken 26e und 27e, die mit einem Schraubklemmanschlusselement 20e bzw. 22e verbunden sind, stehen Klemmanschlüsse 39 und 40 vor. Zwischen je zwei Schenkeln der Klemmanschlüsse 39,40 sind von der Unterseite eines (nicht gezeigten) Stromzählers vorstehende Kontaktmesser einschiebbar. Zwischen den Leiterstücken 26e und 27e besteht verbindung über einen Shuntwiderstand 32e. Über die Kontaktanschlüsse 39,40 lässt sich ein über dem Shuntwiderstand 32e abfallende Messspannung durch den Stromzähler angreifen und auswerten.

Die gezeigte Befestigungs- und Kontaktiereinrichtung 10e ist durch den Shuntwiderstand 32e für die Verwendung mit einem lediglich das Spannungsabfall abgreifende und auswertenden Stromzähler modifiziert. Die Befestigungs- und Kontaktierungseinrichtung diente ursprünglich zum Anschluss über die Anschlusskontakte 39,40 vom Zählstrom durchflossenen Stromzählers.

## Patentansprüche

1. Stromzähleranschlusssystem der Elektroinstallation von Gebäuden, mit einer Stromzählerbaueinheit (1) und einer Befestigungs- und Kontaktiereinrichtung (10), an welche die Stromzählerbaueinheit (1) elektrisch und mechanisch koppelbar und die mit zu zählenden Strom zuführenden und gezählten Strom abführenden Leitern verbindbar ist,
**dadurch gekennzeichnet,**
**dass** die Befestigungs- und Kontaktiereinrichtung (10) Mittel (32) zur Erzeugung eines von der Stärke des zu zählenden Stroms abhängigen, durch die Stromzählerbaueinheit (1) auswertbaren elektrischen Signals aufweist, und dass im Zuge der Ankopplung der Stormzöhlerbaueinheit (1) an die Befestigungs- und Kontaktiereinrichtung (10) das Signal führende Leitungen (33,34) der Befestigungs- und Kontaktiereinrichtung (10) mit der Stromzählerbaueinheit (1) elektrisch verbindbar sind.

2. Stromzähleranschlusssystem nach Anspruch 1,
**dadurch gekennzeichnet,**
**dass** die Leitungen (32,33) im Zuge der mechanischen Ankopplung der Stromzählerbaueinheit (1) an die Befestigungs- und Kontaktiereinrichtung (10) automatisch mit der Stromzählerbaueinheit (1) verbindbar sind.

3. Stromzähleranschlusssystem nach Anspruch 1 oder 2,
**dadurch gekennzeichnet,**
**dass** die Leitungen (33,34) über eine Steckverbindung (7,36) an die Stromzählerbaueinheit (1)anschließbar sind.

4. Stromzöhleranschlusssystem nach einem der Ansprüche 1 bis 3,
**dadurch gekennzeichnet,**
**dass** von einer der Befestigungs- und Kontaktiereinrichtung (10) zugewandten Unterseite (3) der Stromzählerbaueinheit (1) Einrichtungen (7) zur Herstellung einer Steckverbindung mit den Leitungen (33,34) vorstehen.

5. Stromzähleranschlusssystem noch einem der Ansprüche 1 bis 4,
**dadurch gekennzeichnet,**
**dass** in einer die Stromzählerbaueinheit (1) aufnehmenden Zählertragplatte (11) der Befestigungs- und Kontaktiereinrichtung (10) eine Öffnung (12) für den Eingriff von der Stromzählerbaueinheit (1) vorstehende Einrichtungen (7) für die Herstellung einer Steckverbindung zu den Leitungen (33,34) vorgesehen ist.

6. Stromzähleranschlusssystem nach einem der Ansprüche 1 bis 5,
**dadurch gekennzeichnet,**
**dass** die Stromzählerbaueinheit (1) zur mechanischen Ankopplung an die Befestigungs- und Kontaktiereinrichtung (10) unter Verschiebung auf einer Zählertragplatte (11) mit der Tragplatte (11) verhakbar ist.

7. Stromzähleranschlusssystem nach Anspruch 6,
**dadurch gekennzeichnet,**
**dass** automatisch mit der Verschiebung der Stromzählerbaueinheit (1) auf der Tragplatte (11) die Verbindung zwischen den Leitungen (33,34) und der Stromzählerbaueinheit (1) herstellbar ist.

8. Stromzähleranschlusssystem nach einem der Ansprüche 1 bis 7,
**dadurch gekennzeichnet,**
**dass** das elektrische Signal ein über einem von zu zählenden Strom durchflossenen Messwiderstand, insbesondere einen z.B. Konstantan oder/und Manganin aufweisenden Shuntwiderstand, abfallendes Spannungssignal ist

9. Stromzähleranschlusssystem nach einem der Ansprüche 1 bis 8,
**dadurch gekennzeichnet,**
**dass** die Befestigungs- und Kontaktiereinrichtung (10a) eine Schalteinrichtung (39) zur Unterbrechung durch die Befestigungs- und Kontaktiereinrichtung (10a) fließenden, zu zählenden Stromes aufweist.

10. Stromzähleranschlusssystem nach einem der Ansprüche 1 bis 9,
**dadurch gekennzeichnet,**
**dass** die Befestigungs- und Kontaktiereinrichtung (10) Mittel (21,25,28,29,31) zum Abgreifen einer Versorgungsspannung für den Stromzähler (1), die Schalteinrichtung (39) oder/und wenigstens ein weiteres Zusatzgerät vor oder/und hinter der Einrichtung (32) zur Erzeugung des elektrischen Signals aufweist.

11. Stromzähleranschlusssystem nach Anspruch 9,
**dadurch gekennzeichnet,**
**dass** die Schalteinrichtung (39) in der Befestigungs- und Kontaktiereinrichtung (10a) vor oder hinter der Einrichtung zur Erzeugung des elektrischen Signals angeordnet ist und dass Mittel zum Abgreifen einer Vorsorgungsspannung zumindest für die Schalteinrichtung (39) vor der Schalteinrichtung vorgesehen sind.

12. Stromzähleranschlusssystem nach Anspruch 10 oder 11,
**dadurch gekennzeichnet,**
**dass** die Schalteinrichtungen (39) fernsteuerbar sind.

13. Stromzähleranschlusssystem nach einem der Ansprüche 8 bis 12,
**dadurch gekennzeichnet,**
**dass** der Messwiderstand durch Materialabtragung, durch Materialauftrag oder/und durch Variation der Durchflusslänge des Stroms auf einen bestimmten Widerstandswert eingestellt ist.

14. Stromzähleranschlusssystem nach einem der Ansprüche 1 bis 13,
**dadurch gekennzeichnet,**
**dass** die Stromzählerbaueinheit (1) oder die Befestigungs- und Kontaktierenrichtung (10) einen Temperaturfühler zur Erzeugung eines Korrektursignals aufweist.

15. Stromzählerbaueinheit (1) oder Befestigungs- und Kontaktiereinrichtung (10) für ein Stromzähleranschlusssystem nach einem der Ansprüche 1 bis 14.
